# FASCICULE DE BREVET EUROPEEN

(11) **EP 1 668 726 B1**
(45) Date de publication et mention de la délivrance du brevet: **13.10.2010**
(21) Numéro de dépôt: 04767343.9
(22) Date de dépôt: 14.06.2004
(51) Int. Cl.: H01M 8/02, H01M 8/04, H01L 35/28

(54) **COGENERATION D’ELECTRICITE PAR UTILISATION DE L’EFFET SEEBECK A L’INTERIEUR D’UNE PILE A COMBUSTIBLE**
KO-ERZEUGUNG VON ELEKTRIZITÄT MITTELS DES SEEBECK-EFFEKTS IN EINER BRENNSTOFFZELLE
CO-GENERATION OF ELECTRICITY BY THE SEEBECK EFFECT WITHIN A FUEL CELL

(30) Priorité: 16.06.2003 FR 0307187
(43) Date de publication de la demande: 14.06.2006
(73) Titulaire: Renault S.A.S., 92100 Boulogne-Billancourt (FR)
(72) Inventeur: OLIVIER, Gérard, F-78380 Bougival (FR); SAMUEL, Sébastien, F-78460 Choisel (FR); YU, Robert, F-78990 Elancourt (FR)
(86) Numéro de dépôt international: PCT/FR2004/001480
(87) Numéro de publication internationale: WO 2005/004263

(56) Documents cités:
- DE-C- 19 825 872
- PATENT ABSTRACTS OF JAPAN vol. 2002, no. 09, 4 septembre 2002 (2002-09-04) -& JP 2002 141077 A (SONY CORP), 17 mai 2002 (2002-05-17)
- PATENT ABSTRACTS OF JAPAN vol. 2003, no. 07, 3 juillet 2003 (2003-07-03) -& JP 2003 086223 A (NIPPON STEEL CORP), 20 mars 2003 (2003-03-20)
- PATENT ABSTRACTS OF JAPAN vol. 2002, no. 12, 12 décembre 2002 (2002-12-12) -& JP 2002 238272 A (TOKYO GAS CO LTD), 23 août 2002 (2002-08-23)

## Description

La présente invention concerne une pile à combustible et un procédé de récupération d'énergie thermique en énergie électrique.

Les piles à combustible permettent la conversion directe de l'énergie libre d'une réaction chimique d'oxydo-réduction en énergie électrique et apparaissent comme l'une des technologies les plus prometteuses du moment dans le domaine de l'automobile, pour répondre aux exigences européennes de réduction de la pollution et de la consommation.

Cependant, l'inconvénient du système réside dans la gestion des énergies thermiques. En effet, le circuit de refroidissement d'une pile à combustible doit évacuer en énergie thermique environ 1,5 fois la puissance électrique produite. Cela constitue une perte importante d'énergie qui réduit notablement le rendement du système.

Il est donc intéressant de disposer de moyens permettant de valoriser la puissance thermique émise par la pile à combustible en la transformant en énergie utilisable pour le véhicule.

Le brevet DE 1982 5872 décrit une pile à combustible de type SOFC à haute température enfermée dans un encapsulage à double paroi constitué d'une paroi chaude au contact de la pile et d'une paroi froide, refroidie par un média quelconque. Entre ces deux parois sont disposés des éléments thermoélectriques qui produisent un courant électrique du fait de la différence de température, qu'ils subissent entre ces deux parois. Le système de récupération de l'énergie thermique se trouvant à l'extérieur de la pile à combustible, ce dispositif connu ne permet pas d'obtenir un rendement intéressant en raison des pertes thermiques constatées. Le brevet JP 2002141077 décrit une cellule élementaire d'une pile à combustible comprenant un élément thermoélectrique.

L'invention a pour objet une pile à combustible comprenant des moyens de récupération de l'énergie thermique produite par la pile en énergie électrique limitant le plus possible les pertes énergétiques, et permettant d'obtenir un rendement amélioré, ainsi qu'un procédé de récupération de l'énergie thermique en énergie électrique dans une telle pile à combustible.

La pile à combustible selon l'invention comprend au moins deux cellules élémentaires pour réaction exothermique de combustion constituant une source chaude disposées en regard et un canal interne formé entre les cellules pour la circulation d'un fluide de refroidissement constituant une source froide. Cette pile comprend une pluralité de modules thermoélectriques comprenant chacun un couple d'éléments de deux matériaux conducteurs de nature différente. Une première extrémité de chaque couple est en contact thermique avec la source chaude ou la source froide, tandis que la deuxième extrémité de chacun des éléments dudit couple est en contact avec l'autre source, et est électriquement reliée à un module voisin.

Grâce à cette pluralité de modules thermoélectriques disposés à l'intérieur même de la pile, l'énergie thermique produite par les cellules de la pile est convertie en énergie électrique en minimisant les pertes énergétiques du système. De plus, cette réalisation est plus simple à mettre en oeuvre et est moins coûteuse.

De préférence, la pile à combustible utilisée est une pile à membrane de type PEM.

Dans un mode de réalisation avantageux, le module thermoélectrique est constitué d'un couple de matériaux conducteurs reliés en l'une de leurs extrémités par une connexion thermiquement et électriquement conductrice en contact thermique avec la source chaude, et reliés entre eux par leurs extrémités libres par une connexion thermiquement et électriquement conductrice en contact thermique avec la source froide.

Dans un mode de réalisation préféré, les deux matériaux conducteurs des modules thermoélectriques sont des semi-conducteurs, l'un de type P, c'est-à-dire un semi-conducteur dopé positivement, l'autre de type N, c'est-à-dire un semi-conducteur dopé négativement.

Dans un mode de réalisation avantageux, les matériaux de type N sont des alliages de silicium et de germanium dopés au phosphore. Les matériaux de type P sont des alliages de silicium et de germanium dopés au bore.

Avantageusement, les connexions conductrices reliant les extrémités des matériaux sont constituées d'électrodes de molybdène.

Dans un mode de réalisation préféré, le dernier module thermoélectrique d'un ensemble disposé le long d'une première cellule élémentaire est relié électriquement en série ou en parallèle avec le premier module thermoélectrique d'un ensemble disposé le long d'une seconde cellule élémentaire.

Avantageusement, une plaque formant paroi munie d'ailettes est disposée sur la surface externe d'un ensemble de modules thermoélectriques, constituant une délimitation du canal de refroidissement, les ailettes étant disposées du côté du canal de refroidissement afin de favoriser les échanges thermiques.

Le procédé de l'invention pour la récupération de l'énergie thermique en énergie électrique provenant d'une pile à combustible utilise un fluide de refroidissement comme source froide circulant à l'intérieur de la pile à combustible entre deux cellules élémentaires de cette même pile constituant la source chaude. Ce fluide de refroidissement est mis en contact thermique avec une pluralité de modules thermoélectriques. Ainsi l'énergie électrique générée par effet Seebeck est récupérée.

De préférence, le procédé de l'invention utilise une pile à membrane de type PEM, comme pile à combustible.

Avantageusement, ce procédé met en oeuvre un refroidissement de la pile diphasique.

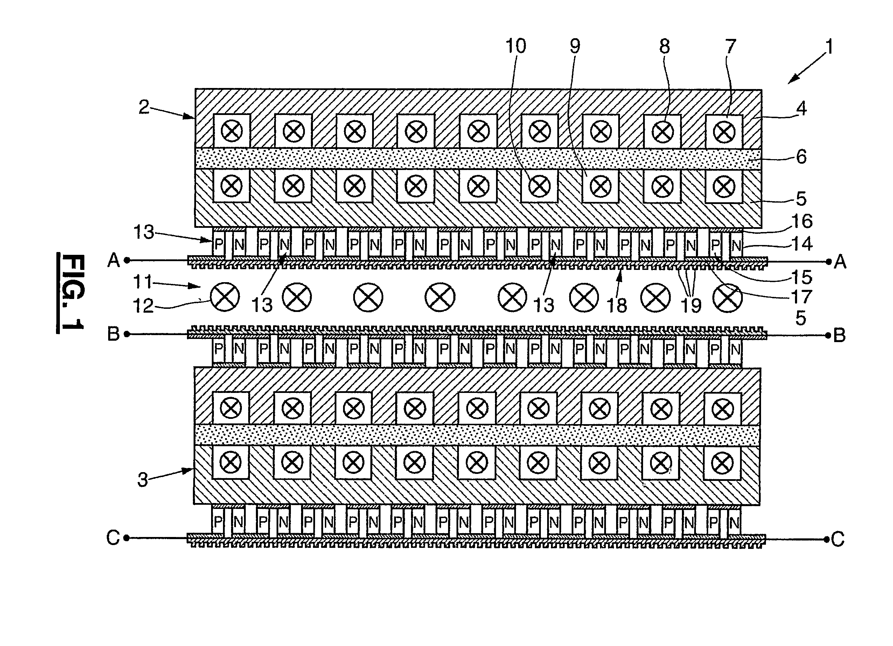

L'invention sera mieux comprise à l'étude de la description détaillée d'un exemple de mode de réalisation pris à titre d'exemple nullement limitatif et illustrée par la figure 1 représentant très schématiquement deux cellules élémentaires d'une pile à combustible selon l'invention.

Sur la figure 1 est représenté un ensemble 1 de deux cellules d'une pile à combustible embarquée sur un véhicule automobile de technologie PEM (Membrane à Echangeuse de Protons). La pile à combustible est constituée d'une succession de cellules élémentaires productrices d'électricité. Sur la figure 1, seules deux cellules élémentaires 2 et 3 sont représentées. Ces cellules élémentaires 2 et 3 sont constituées de deux plaques bipolaires 4 et 5 séparées par une membrane poreuse 6. A la surface de la plaque bipolaire 4 sont gravés des canaux 7 dans lesquels circule de l'oxygène 8. De même, à la surface de la plaque bipolaire 5 sont gravés des canaux 9 dans lesquels circule de l'hydrogène 10. L'oxygène et l'hydrogène circulent perpendiculairement au plan de la figure. La réaction qui se produit dans cette cellule étant exothermique, la température des plaques bipolaires 4 et 5 a tendance à s'élever. Il est donc nécessaire de les refroidir afin d'évacuer des calories.

Les deux cellules productrices 2 et 3 délimitent un canal interne de refroidissement 11 dans lequel circule un fluide caloporteur 12 qui évacue les calories en dehors de la pile. Le fluide caloporteur circule dans un sens perpendiculaire au plan de la figure 1. En sortie de la pile, on refroidit ce fluide 12 grâce à des échangeurs non représentés sur la figure et on le réintroduit froid à l'entrée de la pile à combustible.

Les moyens permettant la conversion de l'énergie thermique en énergie électrique comprennent une pluralité de modules thermoélectriques 13. Cet assemblage de modules thermoélectriques est disposé entre la plaque bipolaire 5 de la cellule élémentaire 2 constituant la source chaude et le canal interne de refroidissement 11, dans lequel circule le fluide de refroidissement 12, qui constitue la source froide. Ces modules sont constitués de deux matériaux conducteurs 14 et 15 de nature différente reliés à l'une de leurs extrémités par une connexion thermiquement et électriquement conductrice 16 en contact thermique avec la source chaude 5. Les modules thermoélectriques sont reliés en série par leurs extrémités libres par une connexion thermiquement et électriquement conductrice 17 en contact thermique avec de la source froide 12.

Les couples de matériaux 14 et 15 sont adaptés au niveau de température de la pile et du circuit de refroidissement.

A titre d'exemple, les matériaux conducteurs qui constituent les modules thermoélectriques sont des matériaux semi-conducteurs. De nature différente, l'un est de type P, c'est-à-dire un semi-conducteur dopé positivement, et l'autre est de type N, c'est-à-dire un semi-conducteur dopé négativement. Les semi-conducteurs de type P sont par exemple des alliages de silicium et de germanium dopés au Bore. Les semi-conducteurs de type N sont par exemple des alliages de silicium et de germanium dopés au phosphore.

Les connexions conductrices 16 et 17 reliant les extrémités des matériaux 14 et 15 sont constituées d'électrodes de molybdène.

Le dernier module thermoélectrique d'un ensemble disposé le long d'une première cellule élémentaire est relié électriquement en série ou en parallèle avec le premier module thermoélectrique d'un ensemble disposé le long d'une seconde cellule élémentaire par les connexions A, B ou C.

Une plaque 18 formant paroi munie d'ailettes 19 est disposée sur la surface externe de l'ensemble des modules thermoélectriques du côté du canal interne de refroidissement 11, les ailettes étant disposées du côté du canal interne de refroidissement 11. L'ajout des ailettes sur la paroi permet d'améliorer les échanges thermiques.

En d'autres termes, des barreaux de matériaux conducteurs 14 et 15 de nature différente sont disposés alternativement en entretoise entre une cellule élémentaire 2 ou 3 d'une pile à combustible 1 et le canal interne de refroidissement 11 adjacent à cette cellule 2 ou 3. Ces barreaux de matériaux conducteurs 14 et 15 sont reliés deux à deux alternativement par des connexions thermiquement et électriquement conductrices, les unes 16 le long de la cellule élémentaire 2 ou 3 constituant la source chaude et les autres 17 le long du canal interne de refroidissement 11, le fluide de refroidissement 12 constituant la source froide. Cette succession de barreaux de matériaux conducteurs constitue la pluralité de modules thermoélectriques 13.

Dans un mode de réalisation préféré, une paroi 18 constituée d'ailettes 19 est disposée perpendiculairement à la succession de barreaux de matériaux conducteurs 14 et 15, le long des connexions conductrices 17, constituant une délimitation du canal interne de refroidissement 11.

Le procédé de mise en oeuvre utilise avantageusement un refroidissement diphasique de la pile à combustible. Dans ce type de refroidissement, les fluides évacuent de la chaleur en s'évaporant à température constante. Cette température pourra être choisie en fonction de la température de fonctionnement voulue de la pile pour optimiser la puissance récupérée. Pour cela, le fluide caloporteur sera choisi en fonction de sa température.

## Revendications

1. Pile à combustible comprenant au moins deux cellules élémentaires (2) (3) pour réaction exothermique de combustion constituant une source chaude et disposées en regard, et un canal interne (11) formé entre les cellules pour la circulation d'un fluide de refroidissement (12) constituant une source froide, ladite pile à combustible comprenant une pluralité de modules thermoélectriques (13) comprenant chacun un couple d'éléments de deux matériaux conducteurs (14) (15) de nature différente, une première extrémité de chaque couple étant en contact thermique avec la source chaude ou la source froide, la deuxième extrémité de chacun des éléments dudit couple étant en contact avec l'autre source, et étant électriquement reliée à un module voisin, le module thermoélectrique etant constitué d'un couple de matériaux conducteurs reliés en l'une de leurs extrémités à une connexion conductrice (16) en contact thermique avec une plaque (5) de la source chaude (2,3), et reliés entre eux par leurs extrémités libres par une connexion conductrice (17) en contact thermique avec la source froide (12)
**caractérisée en ce que** les connexions conductrices (16) (17) reliant les extrémités des matériaux sont constituées d'électrodes de molybdène et **en ce qu'**une plaque (18) formant paroi munie d'ailettes (19) est disposée sur la surface externe de l'ensemble des modules thermoélectriques du côté du canal interne de refroidissement (11).

2. Pile à combustible selon la revendication 1, **caractérisée en ce que** les deux matériaux conducteurs (14) (15) des modules thermoélectriques (13) sont des matériaux semi-conducteurs, l'un de type P, l'autre de type N.

3. Pile à combustible selon l'une quelconque des revendications 1 ou 2, **caractérisée en ce que** les matériaux (13) de type N sont des alliages de silicium et de germanium dopés au phosphore et les matériaux de type P (14) sont des alliages de silicium et de germanium dopés au bore.

4. Pile à combustible selon l'une quelconque des revendications 1 à 3, **caractérisée en ce que** le dernier module thermoélectrique d'un ensemble disposé le long d'une première cellule élémentaire (2) est relié électriquement en série ou en parallèle avec le premier module thermoélectrique d'un ensemble disposé le long d'une seconde cellule élémentaire (3).

## Claims

1. Fuel cell assembly comprising at least two elementary cells (2) (3) for an exothermic combustion reaction constituting a hot source, said cells facing one another, and an internal channel (11) formed between the cells for the circulation of a coolant (12) constituting a cold source, said fuel cell assembly comprising a plurality of thermoelectric modules (13) each comprising a couple of elements of two conducting materials (14) (15) of different nature, a first end of each couple being in thermal contact with the hot source or the cold source, the second end of each of the elements of said couple being in contact with the other source and being electrically connected to an adjacent module, the thermoelectric module consisting of a couple of conducting materials that are connected at one of their ends to a conducting connection (16) in thermal contact with a plate (5) of the hot source (2, 3) and are connected together via their free ends by a conducting connection (17) in thermal contact with the cold source (12),
**characterized in that** the conducting connections (16) (17) connecting the ends of the materials consist of molybdenum electrodes and **in that** a plate (18) forming a wall provided with fins (19) is placed on the external surface of the set of thermoelectric modules on the side facing the internal cooling channel (11).

2. Fuel cell assembly according to Claim 1, **characterized in that** the two conducting materials (14) (15) of the thermoelectric modules (13) are semiconductor materials, one being of p-type and the other being of n-type.

3. Fuel cell assembly according to either of Claims 1 and 2, **characterized in that** the n-type materials (13) are silicon-germanium alloys doped with phosphorus and the p-type materials (14) are silicon-germanium alloys doped with boron.

4. Fuel cell assembly according to any one of Claims 1 to 3, **characterized in that** the last thermoelectric module of a set placed along a first elementary cell (2) is electrically connected in series or in parallel with the first thermoelectric module of a set placed along a second elementary cell (3).

## Patentansprüche

1. Brennstoffzelle mit mindestens zwei Elementarzellen (2) (3) für eine exotherme Verbrennungsreaktion, die eine heiße Quelle bilden und gegenüberliegend angeordnet sind, und einem inneren Kanal (11), der zwischen den Zellen für die Zirkulation eines Kühlfluids (12) gebildet ist, das eine kalte Quelle bildet, wobei die Brennstoffzelle mehrere thermoelektrische Module (13) mit jeweils einem Paar von Elementen aus zwei leitenden Materialien (14) (15) verschiedener Art aufweist, wobei ein erstes Ende von jedem Paar mit der heißen Quelle oder der kalten Quelle in Thermokontakt steht, das zweite Ende von jedem der Elemente des Paars mit der anderen Quelle in Kontakt steht und mit einem Nachbarmodul elektrisch verbunden ist, wobei das thermoelektrische Modul aus einem Paar von leitenden Materialien besteht, die an einem ihrer Enden mit einer leitenden Verbindung (16) in Thermokontakt mit einer Platte (5) der heißen Quelle (2, 3) verbunden sind und an ihren freien Enden durch eine leitende Verbindung (17) in Thermokontakt mit der kalten Quelle (12) miteinander verbunden sind,
**dadurch gekennzeichnet, dass** die leitenden Verbindungen (16) (17), die die Enden der Materialien verbinden, aus Molybdänelektroden bestehen und eine Platte (18), die eine Wand bildet, die mit Stegen (19) versehen ist, an der äußeren Oberfläche der Baugruppe der thermoelektrischen Module auf der Seite des inneren Kühlkanals (11) angeordnet ist.

2. Brennstoffzelle nach Anspruch 1, **dadurch gekennzeichnet, dass** die zwei leitenden Materialien (14) (15) der thermoelektrischen Module (13) Halbleitermaterialien sind, eines vom P-Typ, das andere vom N-Typ.

3. Brennstoffzelle nach einem der Ansprüche 1 oder 2, **dadurch gekennzeichnet, dass** die Materialien (13) vom N-Typ mit Phosphor dotierte Legierungen von Silizium und Germanium sind und die Materialien (14) vom P-Typ mit Bor dotierte Legierungen von Silizium und Germanium sind.

4. Brennstoffzelle nach einem der Ansprüche 1 bis 3, **dadurch gekennzeichnet, dass** das letzte thermoelektrische Modul einer Baugruppe, das entlang einer ersten Elementarzelle (2) angeordnet ist, mit dem ersten thermoelektrischen Modul einer Baugruppe, das entlang einer zweiten Elementarzelle (3) angeordnet ist, elektrisch in Reihe oder parallel geschaltet ist.
